Europäisches Patentamt

European Patent Office

Office européen des brevets

(11) Publication number: 0 652 304 A1

# EUROPEAN PATENT APPLICATION

(21) Application number: 94114707.6

(22) Date of filing: 19.09.94

(51) Int. Cl.6: **C23C 16/52**, C23C 14/54

(30) Priority: 17.09.93 JP 231253/93

(43) Date of publication of application:
10.05.95 Bulletin 95/19

(84) Designated Contracting States:
DE FR GB

(71) Applicant: HITACHI, LTD.
6, Kanda Surugadai 4-chome
Chiyoda-ku,
Tokyo 101 (JP)

(72) Inventor: Maeda, Yoshihito
3-4-36-601 Oomachi
Mito-shi,
Ibaraki 310 (JP)
Inventor: Leblanc, François
20-1, Mizuki-cho 2-chome
Hitachi-shi,
Ibaraki 316 (JP)
Inventor: Minemura, Tetsuo
3115-13, Mayumi-cho
Hitachioota-shi,
Ibaraki 313 (JP)

(74) Representative: Patentanwälte Beetz - Timpe -
Siegfried Schmitt-Fumian - Mayr
Steinsdorfstrasse 10
D-80538 München (DE)

(54) Film forming method and apparatus for carrying out the same.

(57) A film forming apparatus comprises a film forming system comprising a film forming arrangement necessary for forming films; and a film monitoring system comprising a light source (40), a light-transmissive solid member (38), a signal transmitting means for transmitting light signals to the light-transmissive solid member (38), a driving unit for driving the light-transmissive solid member (38) for rotation about the optical axis of the light signals, an optical measuring unit comprising a spectroscope (53) and an optical detector (55), and a calculating unit (48). A film forming method comprises measuring the attenuation factor of transmitted light transmitted through a light-transmissive solid member (38) and attenuated by a thin film formed over the surface of the light-transmissive solid member (38) as a function of the wavelength of the transmitted light, and controlling film forming conditions according to data representing changes in the thickness and the optical constant of a thin film formed over the surface of a film monitor (36) formed in the light-transmissive solid member (38), in a real-time control mode taking multiple interference in the thin film into consideration.

FIG. 3

BACKGROUND OF THE INVENTION

The present invention relates to a method of forming high-quality thin films of semiconductors, dielectrics and metals to be used in the electronic industry and the optical industry.

Thin films of semiconductors, dielectrics and metals have widely been applied to electronic devices and optical instruments, and high-quality thin films meeting the requirements of advanced electronic devices and optical instruments have been needed. Ex-situ measurement of the quality of films, i.e., measurement of the quality of films after the films have been formed, does not suffice for providing such high-quality films. Generally, since a film is formed by the condensation of the elements of source gases having high energy, modes of nuclei formation and growth of nuclei on the surface of a substrate are greatly dependent on film forming conditions. Particularly, variation of parameters of the film forming process including the temperature of the substrate, the pressures of the source gases, plasma density and such entails formation of a film structure having an irregular morphology and voids in the film. As is generally known, the morphology of the film structure and voids in the film influence greatly the mechanical, optical and electrical characteristics of the film, and the irregular morphology and voids are causes of cracking. Accordingly, the quality of the film must be monitored during the film forming process through the in situ measurement of the quality of the film, i.e., measurement of the quality of the film during the film forming process, and a film forming apparatus provided with a film monitor capable of monitoring the film to detect the variation of the quality of the film during the film forming process is necessary. The in situ measurement of the quality of the film must be started in the initial stage of the film forming process in which the film is very thin.

The conventional film forming apparatus is provided with a quartz oscillation type film thickness monitor for measuring the varying thickness of the film, an ellipsometer and a reflection electron monitor for measuring the physical properties of the film, and an X-ray photoelectron spectroscope (XPS) for inspecting the condition of the film.

A technique for detecting matters in the environment with glass fibers is disclosed in Japanese Patent Application No. 4-503251, and a technique for changing the reflectivity through the reaction between a solution and a waveguide immersed in the solution is disclosed in U.S. Reissue Patent No. 3,3064.

A film forming apparatus provided with a comparatively inexpensive ellipsometer subject to only a few restrictions has been used for forming high-quality amorphous semiconductor films, such as amorphous silicon hydride (a-Si:H) films to be applied to solar cells and thin-film transistors. Generally, the electrical and optical characteristics of amorphous semiconductors are dominated by structural disarrangement or bond defects (dangling bonds). Since the ellipsometer is insufficiently sensitive to the detection of slight changes in the optical and electrical characteristics in the band gap (mid-gap), the ellipsometer is unable to monitor the film quality satisfactorily during the film forming process. The reflection electron monitor and the XPS require accurate determination and maintenance of the positional relation between the monitoring beam and the sample, and the measurement of the thickness of the film in a plasma during the film forming process by the reflection electron monitor and the XPS is difficult because the monitoring beam is subject to the influence of an intense electric field. Therefore, the use of the reflection electron monitor and the XPS is possible only under limited conditions. The quartz oscillation monitor, on principle, is capable of monitoring only the variation of the thickness of the film.

SUMMARY OF THE INVENTION

Accordingly, it is an object of the present invention to provide a film forming method capable of forming a high-quality film and of monitoring the quality of substantially all kinds of thin films in a high sensitivity on a universally applicable measuring principle.

Another object of the present invention is to provide a film forming apparatus capable of forming high-quality thin films and and provided with a high-sensitivity film monitoring means capable of monitoring the quality of substantially all kinds of thin films in a high sensitivity.

With the foregoing objects in view, the present invention provides a film forming apparatus comprising: a film forming system having a film forming chamber; a light source for emitting light signals; an optical waveguide disposed near the film forming unit disposed within the film forming chamber, and provided with a film monitoring means including an exposed portion of the core of the waveguide; a light signal transmitting means for transmitting light signals provided by the light source to the optical waveguide; a driving unit for driving the film monitoring means for rotation; an optical detector for detecting the light sent out from the optical waveguide; and a computing system for calculating changes in the optical characteristics of a thin film formed over the surface of the film monitoring means and a change in the thickness of the thin film on the basis of the output signals of the optical detector.

The present invention provides also a film forming method employing a multimode optical waveguide consisting of a core of $N_1$ in refractive index, a cladding and a protective jacket, comprising: measuring the attenuation factor of transmitted light transmitted through the multimode optical waveguide and attenuated by refraction and interference in a thin film of $N_2$ in refractive index greater than the refractive index $N_1$ of the core, formed over the surface of a film monitor included in the multimode optical waveguide and formed by partly or entirely removing a portion of the cladding of the multimode optical waveguide, as a function of the wavelength of the transmitted light; and determining optimum film forming conditions for forming a thin film of a desired quality on the basis of changes in the thickness and the optical constant of the thin film.

## BRIEF DESCRIPTION OF THE DRAWINGS

The above and other objects, features and advantages of the present invention will become more apparent from the following description taken in connection with the accompanying drawings, in which:

Fig. 1 is a perspective view of a film monitor formed in an optical fiber used as an optical waveguide;

Fig. 2 is a perspective view of another film monitor formed in an optical fiber used as an optical waveguide;

Fig. 3 is a block diagram of a CVD film forming apparatus in a preferred embodiment according to the present invention;

Fig. 4 is a graph of normalized transmittance spectrum;

Fig. 5 is a graph of assistance in explaining measuring sensitivity;

Fig. 6 is a longitudinal sectional view of a waveguide having a film monitor;

Fig. 7 is a schematic view of a film monitor combined with a temperature monitor;

Fig. 8 is a diagrammatic view of a film monitor embedded in a plate;

Fig. 9 is a perspective view of a film monitor embedded in a plane-parallel plate;

Fig. 10 is schematic view of a film monitor employing a plane-parallel plate;

Fig. 11 is a block diagram of a high-frequency sputtering apparatus in another embodiment according to the present invention; and

Fig. 12 is a block diagram of an ion-beam sputtering apparatus in a third embodiment according to the present invention.

## DESCRIPTION OF THE PREFERRED EMBODIMENTS

A waveguide having a high-sensitivity film monitor capable of in situ and ex-situ measurement of the characteristics of a thin film, to be employed in the present invention will be described prior to the description of the preferred embodiments of the present invention.

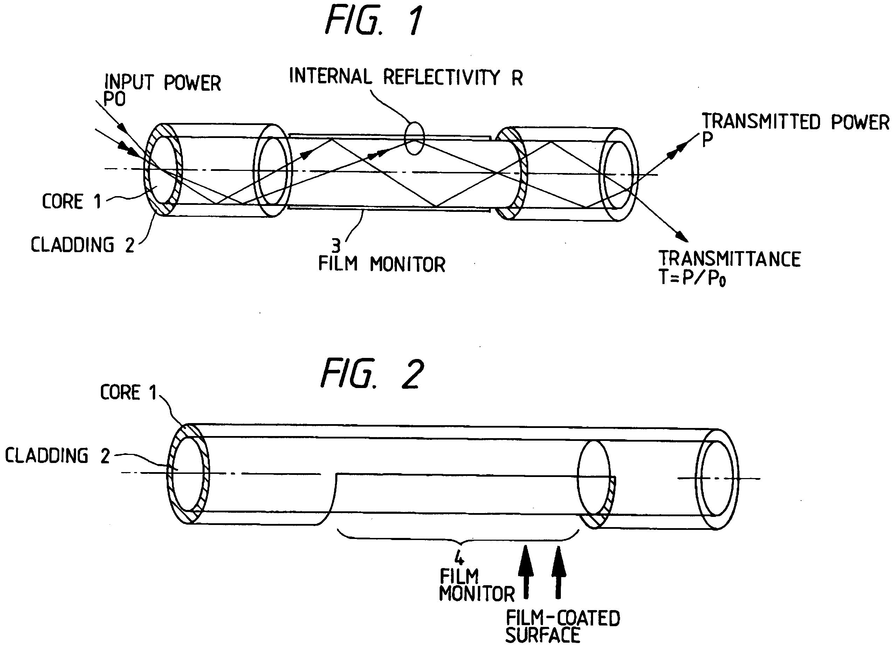

Referring to Fig. 1 showing an optical fiber capable of transmitting light in multiple guided modes, i.e., a multimode optical fiber, serving as an optical waveguide having a film monitor for measuring the characteristics of a thin film, the film monitor is formed by partly or entirely removing a portion of the cladding and a portion of the jacket of the optical fiber corresponding to the film monitor to expose partly or entirely the portion of the core of the optical fiber corresponding to the film monitor. A thin film is formed over the surface of the film monitor during a film forming process for forming a thin film over the surface of a substrate. Measuring light of a wavelength suitable for the material for forming the thin film is emitted by a light source, such as a laser, a halogen lamp, a xenon lamp or a tungsten lamp, and is transmitted by the optical fiber to the film monitor. It is considered that a light beam introduced into an optical fiber having a large diameter core, such as a multimode optical fiber, repeats total reflection at the interface between the core and the cladding at a total reflection angle in a fixed range and travels zigzag. A reflection coefficient at each reflection can be expressed by using Fresnel coefficient $r$. Light is propagated through the optical fiber substantially without loss. However, since the film monitor is an exposed portion of the core and is coated with a light absorptive thin film having a refractive index greater than that of the core, part of the light travels into the thin film and repeats reflection within the thin film and, consequently, the energy of the light is absorbed by the thin film and the light traveling within the thin film is attenuated. The degree of attenuation is substantially proportional to the number of reflections at the interface between the core and the thin film. Therefore, the transmittance spectrum directly related to the optical absorption coefficient $\alpha$ of the thin film coating the film monitor can be determined through the measurement of the transmittance $T = P/P_0$. However, it is to be noted that the transmitted light travels into and refracted within the thin film coating the film monitor, and the multiple reflection of the transmitted light occurs within the thin film. Therefore, the transmittance spectrum of the transmitted light is affected greatly by interference. A monitoring device employed in the present invention positively utilizes the effect of interference for the enhancement of the sensitivity, which is the principal feature of the present invention. The monitor shown in Fig. 1 has been applied to the measurement of the concentration of gases and the components of solutions (refer, for example, to Ruddy, et al., Journal of Applied Physics, Vol. 67, No. 10, p.6070). When the film monitor is applied to the measurement of the concentration of a gas or a component of a solution, an evanescent wave is generated at the interface because the refractive index of the gas or the solution is smaller than that of the core. Therefore, as is generally known, the concentration of the gas or the component of the solution can be determined from the change of the transmittance spectrum of the transmitted light resulting from the absorption of the evanescent wave by the gas or the solution. An ordinary thin film cannot be measured by an analysis method based on this principle, because the refractive index of an ordinary thin film is far greater (about 1.5 times) than that of the core and hence any evanescent wave is not generated at the interface between the ordinary thin film and the core.

The functions of a film monitor will be described with reference to Figs. 1 and 2. A film monitor 4 is a portion of the core of an optical fiber exposed by removing the cladding 2 of the optical fiber. When the surface of the film monitor 4 is coated with a thin film 3 having a refractive index greater than that of the core, the transmitted light is diffracted at the interface between the core and the thin film. When the transmitted light is reflected repeatedly in the film monitor 4,

$$R_r = (R - \Delta R)^{N_r} = R(1 - \Delta R/R)^{N_r} \sim R(1 - N_r(\Delta R/R)) \quad (1)$$

$$\Delta R/R \ll 1$$

where $\Delta R$ is a change in reflectivity when the light is reflected once, and $N_r$ is the number of repetitions of reflection. If $R = 1$ and $\Delta R = 0.01$, $N_r = 50$ and therefor,

$$R_r = 1 - 50 \times 0.01 = 0.5 \quad (2)$$

$$T = P/P_0 = 1 - R_r = 0.5 \quad (3)$$

Thus, the number $N_r$ of repetitions of the total reflection of the transmitted light in the film monitor 4 improves the total reflection loss or the change of the transmittance. Accordingly, it is considered that the measuring sensitivity is dominated by the number $N_r$ of repetitions of total reflection of the transmitted light in the film monitor 4, and hence the geometrical conditions of the optical waveguide must selectively be determined to provide a necessary measuring sensitivity. A film monitor may be formed by removing part of a portion of the cladding of an optical fiber corresponding to the film monitor as shown in Fig. 2. When the optical fiber has the film monitor shown in Fig. 2, the optical fiber is disposed so that a thin film is deposited over the exposed surface of the core.

The geometrical design data of a film monitor formed in a multimode optical fiber will be described hereinafter. A parameter $\rho f$ is expressed by:

$$\rho f = L_c/R_c \quad (4)$$

where $L_c$ is the length of the film monitor and $R_c$ is the radius of the film monitor, i.e., the radius of the core. Since the numerical aperture NA of an ordinary optical fiber is 0.4,

$$N_r \sim \rho f/15 \quad (5)$$

For example, when $L_c = 100$ mm and $R_c = 0.1$ mm, $N_r \sim 67$. When $N_r = 67$, an absorption coefficient not greater than $\alpha = 10$ cm$^1$ can be measured when the thickness of the thin film is several nanometers. It is known from expression (4) that the sensitivity can be enhanced by increasing $N_r$ by increasing $L_c$ or decreasing $R_c$. It is known from the analysis of guided mode that $R_c$ must be greater than 5 $\mu$m. If $L_c = 100$ mm, a maximum $N_{rmax}$ is on the order of 1330 and, theoretically, the absorption coefficient $\alpha$ of a thin film having a thickness of about several angstroms smaller than 10 cm$^1$ can be measured. Photothermal deflection spectroscopy (PDS) is very sensitive and has been used for the ex-situ measurement of a very small electron state density caused by defects within the band gap of amorphous semiconductor thin films. The sensitivity index $\alpha d$ (d is the film thickness) of PDS is on the order of $10^4$. In the film monitoring system of the present invention, $\alpha d = 10^5$ when $\rho f = 1000$, and the sensitivity of the film monitoring system is about 10 times higher than that of PDS.

First Embodiment

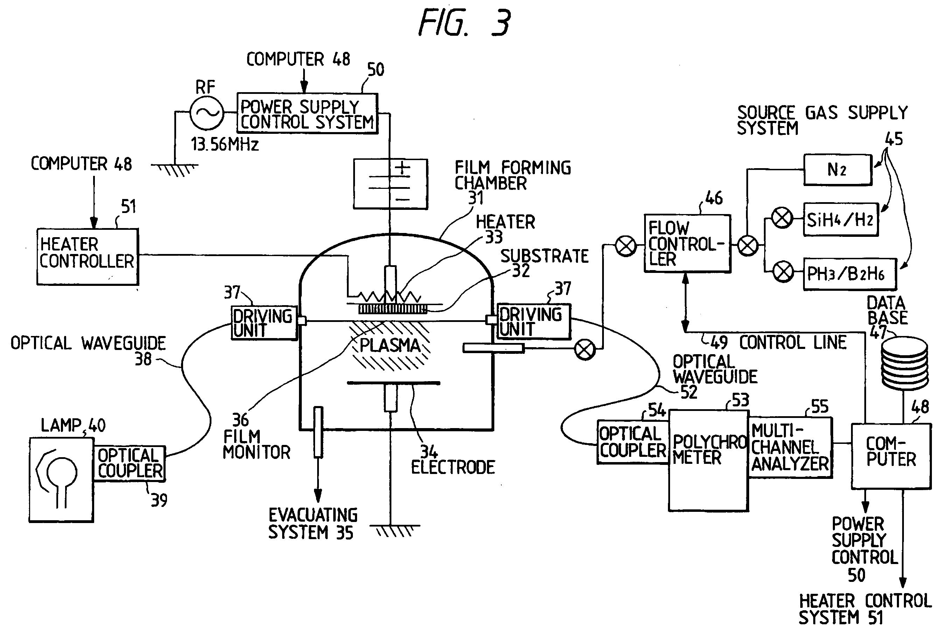

Referring to Fig. 3 showing a chemical vapor deposition system (CVD system) in a first embodiment according to the present invention for forming an amorphous silicon thin film, source gases having partial pressures controlled by a flow controller 46 are supplied through a nozzle into a film forming chamber 31, the source gases are decomposed by plasma discharge produced by applying a high-frequency voltage across opposite electrodes, and the elements of the source gases are deposited in a thin film on a substrate 32. A film monitor 36 as shown in Fig. 1 or 2 formed in a waveguide 38 is held stationary or rotated at a rotating speed on the order of 15 rps during the film forming process. Thin films are formed simultaneously over the surface of the substrate 32 and the surface of the film monitor 36. The receiving end of the waveguide 38 is connected to a lamp 40, i.e., a light source, with a coupler 39 to receive light emitted by the lamp 40. The light is transmitted through the optical waveguide 38, part of the light is absorbed by the thin film coating the surface of the film monitor 36 and, consequently, the light is attenuated. The attenuated light is transmitted through an optical waveguide 52 to a polychrometer 53 and a multichannel optical detector 55, and a spectrum of the attenuated light is produced. A computer 48 analyzes measured data obtained by measuring the spectrum with reference to film forming information fetched from a data base 47. If the measured data deviates from reference data representing a desired spectrum, the computer 48 sends control signals through a control line 49 to the flow controller 46, a power supply control system 50 a heater control system 51 for controlling a heater 33 for heating the substrate 32 for the real-time control of the partial pressures of the source gases, the temperature of the substrate 32 and the high-frequency voltage applied across the opposite electrodes to form a thin film of a desired quality. A Fabry-Péot etalon interferometer and an optical detector may be used instead of the polychrometer and the multichannel analyzer for the precision measurement of the attenuated light having a wavelength in the infrared region. Arrangements similar to that of the CVD system in the first embodiment may be applied to CVD systems other than the CVD system in this embodiment, such as electron cyclotron resonance plasma chemical vapor deposition systems (ECR plasma CVD systems) and photoassisted CVD systems.

An a-Si:H thin film was formed by the CVD system in the first embodiment. The length $L_c$ of the film monitor was 100 mm, and the radius $R_c$ of the core was 100 $\mu$m. Measured wavelengths are in the range of 500 to 1500 nm, which corresponds to the optical band gap of the a-Si:H thin film. Therefore the effect of changes in film quality, such as the density of defects and structural disarrangement, appears conspicuously in this wavelength range.

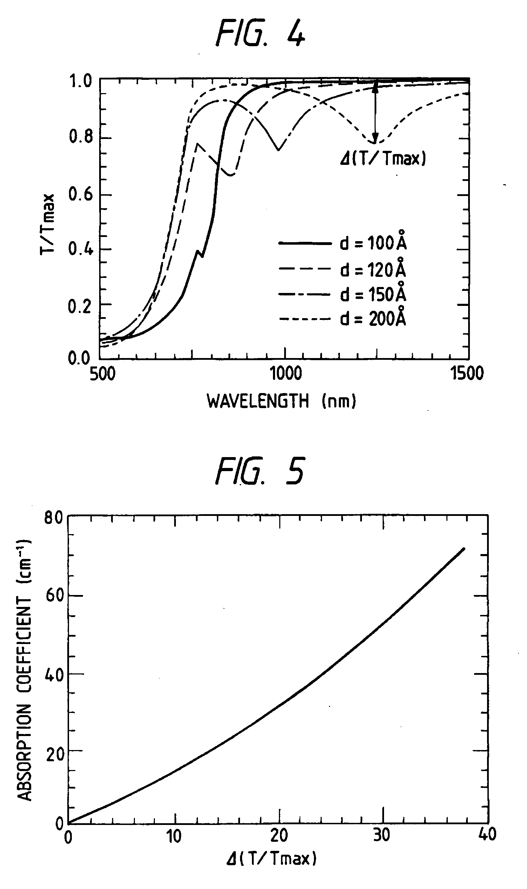

Fig. 4 shows normalized spectra ($T/T_{max}$) of the transmitted light for the thicknesses 100 Å, 120 Å, 150 Å and 200 Å of the a-Si:H thin film. Each spectrum has an absorption peak caused by interference. The wavelength corresponding to the absorption peak shifts regularly toward the longer wavelengths as the thickness of the a-Si:H thin film increases. The variation of defect level density caused by various defects in the a-Si:H thin film and the structural uniformity of the a-Si:H thin film could be known from the regular shifting of the absorption peak $\Delta(T/T_{max})$ according to the variation of the film thickness during the film forming process. An a-Si:H thin film of a desired quality could be formed by varying only the temperature of the substrate in a 10°C temperature range according to the difference between the spectrum produced by real-time measurement of the transmitted light and a transmission spectrum stored beforehand in the data base.

Fig. 5 shows the variation of the absorption coefficient with the absorption peak $\Delta(T/T_{max})$ when the film thickness is 200 Å. A maximum sensitivity that can be achieved by the ordinary photothermal deflection spectroscopic measurement is on the order of 50 cm[1]. The sensitivity of the film monitor of the present invention is on the order of 5 cm[1], which is about ten times higher than that which can be achieved by the ordinary photothermal deflection spectroscopic measurement, when $\Delta(T/T_{max})$ is about 3%. Optical state density can be determined from the absorption peak by calculation taking optical interference into consideration.

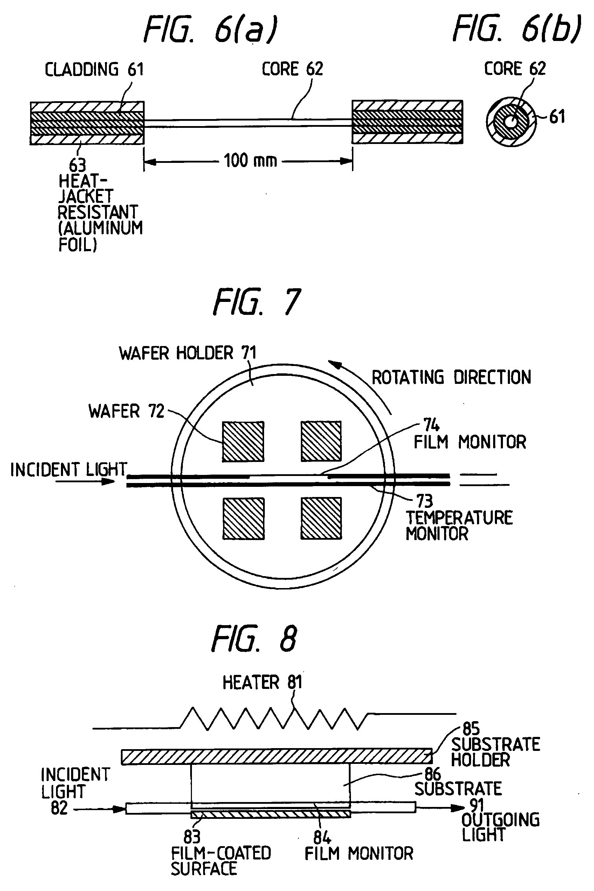

Fig. 6 shows a practical structure of an optical fiber having a film monitor. The length $L_c$ of the film monitor is 100 mm. The optical fiber has a core 62, a cladding 61 cladding the core 62, and a heat-resistant jacket 63 of a metal, such as aluminum, or a ceramic, coating the cladding 61 to protect the core 62 from the heat of the plasma. An optical fiber may be combined with the film monitor of the optical fiber as shown in Fig. 7 to correct the variation of the refractive index of the optical fiber caused by the heat of the plasma.

Second Embodiment

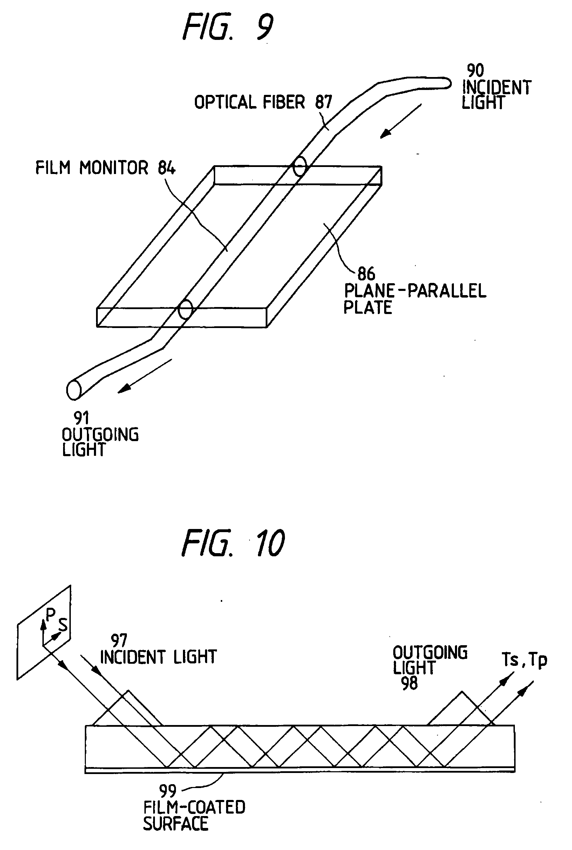

Figs. 8 and 9 show a film monitor 84 employed in a CVD system in a second embodiment according to the present invention. This film monitor 84 is formed by embedding a film monitoring section of an optical fiber in a surface of a flat plate 86. This film monitor 84 is effective when a substrate must be heated to form a high-quality thin film thereon. The plate 86 is heated on the back side while a thin film is being formed over the surface thereof in which the film monitoring section of the optical fiber is embedded. The quality of the thin film can be measured while the thin film is being formed. It is known that the quality of an a-Si:H film is greatly dependent on the temperature of the substrate during the film forming process. The use of this film monitor 84 is capable of monitoring actual film forming conditions. Since the surface of the plate 86 is flat, a uniform thin film can be formed. The film monitor 84 need not be rotated during the film forming process.

Fig. 10 shows a plane-parallel plate serving as a film monitor. Light falls through a 45° prism on the plane-parallel plate, travels through the plane-parallel plate, repeating reflection, and leaves the plane-parallel plate through another prism. Part of the light is absorbed by a thin film formed over one of the major surfaces of the plane-parallel plate every time the light is reflected. Since the plane of polarization of the incident light is maintained, ellipsometric analysis is possible. Basically, the mode of attenuation of the light in this film monitor is the same as that of the light in the film monitor formed in the optical fiber. Even in the initial stage of the film forming process, the same thin film as that formed over the surface of the substrate is formed over the surface of the plane-parallel plate. This film monitor is capable of measuring the quality of the thin film in a high sensitivity.

Third Embodiment

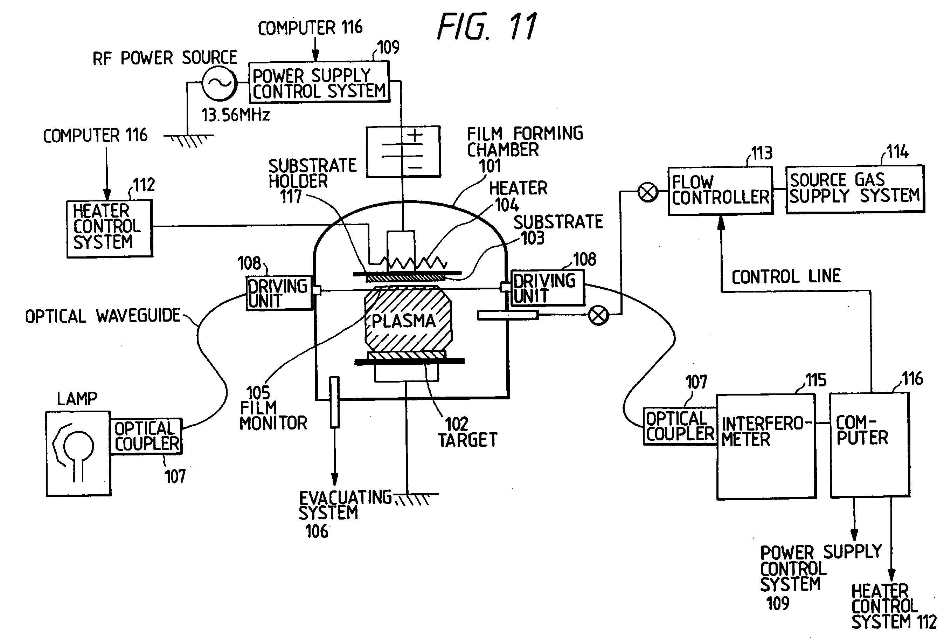

Referring to Fig. 11 showing a sputtering film forming system in a third embodiment according to the present invention, sputtering gases having controlled partial pressures controlled by a flow controller 113 is supplied into a film forming chamber 101 through a nozzle and a high-frequency voltage is applied to opposite electrodes to produce a plasma. Ions of the plasma impact against a target 102 to cause the target 102 to sputter particles, which are deposited in a thin film over the surface of a substrate 103. This sputtering film forming system is provided with the film monitor shown in Fig. 1 or 2. The film monitor is rotated at a rotating speed on the order of 15 rps or is held stationary so that a thin film is formed over the surface of the film monitor as a thin film is formed over the surface of the substrate 103. Light emitted by a lamp, i.e., a light source, is transmitted by the optical fiber connected to the lamp by a coupler 107 to the film monitor 105. Part of the light is absorbed by the thin film formed over the surface of the film monitor 105 on the aforesaid principle and the light is attenuated. The attenuation of the light is measured and a spectrum is formed by a Fabry-Péot etalon interferometer 115 and an optical detector 107. A computer 116 analyzes the measured data with reference to a data base. If the measured spectrum deviates from a reference spectrum, the computer 116 sends control signals through a control line to the flow controller 113, a power supply control system 109 and a heater control system 112 to control the partial pressures of the sputtering gases, the temperature of the substrate 103 and the high-frequency voltage applied across the electrodes in a real-time mode. A polychrometer and a multichannel analyzer may be used for measuring the attenuated light. Arrangements similar to that of this plasma sputtering system can be applied to various sputtering systems, such as dc sputtering systems, other than the plasma sputtering system in this embodiment. Metal thin films of metals capable of being caused to sputter, such as aluminum and gold, and dielectric thin films could be formed in high quality by the plasma sputtering system in this embodiment.

Fourth Embodiment

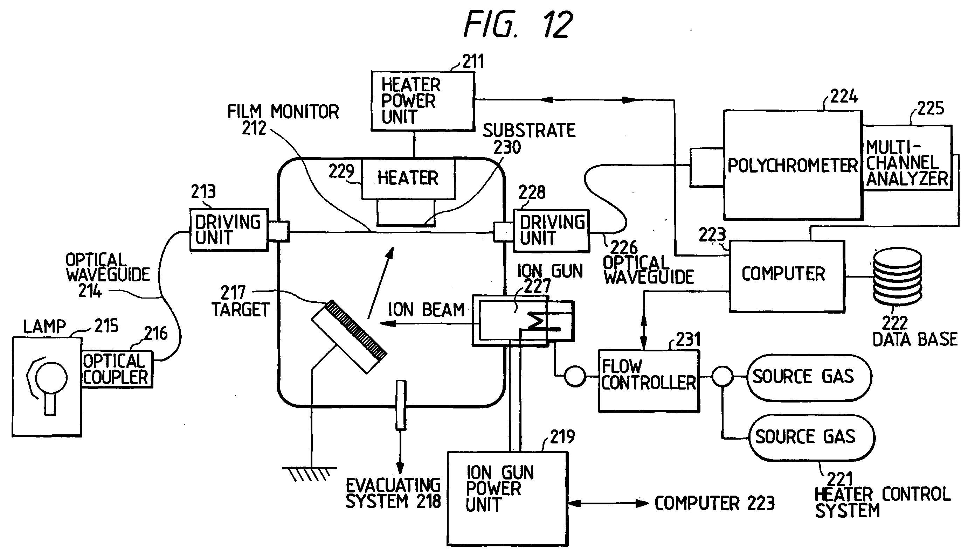

Referring to Fig. 12 showing an ion beam sputtering system in a fourth embodiment according to the present invention, an ion gun 226 ionizes sputtering gases having partial pressures controlled by a flow controller 231 to produce an ion beam and irradiates a target 217 with the ion beam to cause the target 217 to sputter particles, which are deposited in a thin film over the surface of a substrate 230. The ion beam sputtering system is provided with a film monitor 212 similar to the film monitor shown in Fig. 1 or 2, which is rotated at a rotating speed on the order of 15 rps or held stationary. A thin film is formed over the surface of the film monitor simultaneously with the thin film formed over the surface of the substrate 230. Light emitted by a lamp 215, i.e., a light source, is transmitted by an optical waveguide 214 connected to the lamp 215 by a coupler 216 to the film monitor 212. Part of the light is absorbed and the light is attenuated by the thin film formed over the surface of the film monitor 212 on the aforesaid principle. The attenuation of the light is measured and a spectrum is formed by a polychrometer 224 and a multichannel analyzer 225. A computer 223 analyzes the measured data with reference to a data base 222 in a real-time mode. If the measured spectrum deviates from a reference spectrum, the computer sends control signals through a control line to the flow controller 231, an ion gun power unit 219 for supplying power to the ion gun 226 and a heater power unit 211 for supplying power to a heater for heating the substrate 230 to control the ion beam flux, the temperature of the substrate 230 and the energy of the ion beam in a real-time mode. A Fabry-Péot etalon interferometer and an optical detector may be employed instead of the polychrometer 224 and the multichannel analyzer 225. Arrangements similar to that of this ion beam sputtering system can be applied to various sputtering systems, such as a dc sputtering systems, other than this ion beam sputtering system. Metal thin films of metals capable of being caused to sputter, such as aluminum and gold, and dielectric thin films could be formed in high quality by this ion beam sputtering system.

Although the invention has been described in its preferred form with a certain degree of particularity, obviously many changes and variations are possible therein. It is therefore to be understood that the present invention may be practiced otherwise than as specifically described herein without departing from the scope and spirit thereof.

**Claims**

1. A film forming apparatus comprising: a film forming vessel defining a film forming chamber (31); a light source (40); an optical waveguide (38) formed of an optical fiber, having a film monitor (36) formed by exposing a portion of the core of the optical fiber, and disposed with its film monitor (36) disposed near a film forming unit disposed within the film forming chamber (31); a light transmission means for transmitting light signals provided by the light source (40) to the optical waveguide (38); a driving unit for driving the film monitor (36) for rotation; an optical detector (55) for detecting the light outgoing from the optical waveguide; and a computing unit (48) that calculates the variations in the optical characteristics and the thickness of a thin film formed over the surface of the film monitor (36) on the basis of the outputs of the optical detector (55).

2. A film forming apparatus comprising: a film forming vessel defining a film forming chamber (31); a light source (40); an optical waveguide (38) formed of an optical fiber, having a film monitor (36) formed by exposing a portion of the core of the optical fiber, and disposed with its film monitor (36) disposed near a film forming unit disposed within the film forming chamber (31); a light transmission means for transmitting light signals provided by the light source (40) to the optical waveguide (38); a driving unit for driving the film monitor (36) for rotation; an optical detector (55) for detecting the light outgoing from the optical waveguide; and a computing unit (48) that calculates the differences in optical characteristics between the thin film formed over the surface of the film monitor (36), and the core of the optical waveguide on the basis of the outputs of the optical detector.

3. A film forming apparatus comprising: a film forming vessel defining a film forming chamber (31); a light source (40); an optical waveguide (38) formed of an optical fiber having a core and a cladding coating the core, and having a film monitor (36) formed by partly or entirely removing a portion of the cladding in a section of the optical fiber extending near a film forming unit disposed within the film forming chamber (31); a driving unit for driving the film monitor for rotation; an optical detector (55) for detecting the amount of light emitted by the light source (40) transmitted through the optical waveguide (38) and outgoing from the optical waveguide; and a computing unit (48) that calculates variations in the optical characteristics and the thickness of a thin film formed over the surface of the film monitor (36) on the basis of the outputs of the optical detector (55).

4. A film forming apparatus comprising:
 a film forming system including a film forming vessel defining a film forming chamber (31), and a film forming unit disposed within the film forming chamber; and
 a film monitoring system comprising a light source (40), a multimode optical fiber (38) consisting of a core, a cladding for cladding the core, and a jacket, and having a film monitor (36) formed by partly or entirely removing a portion of the cladding in a section of the multimode optical fiber (38) extending near the film forming unit, a driving unit for driving the film monitor for rotation, a light measuring unit consisting of a spectroscope (53) and an optical detector (55), for measuring the intensity of light emitted by the light source (40) transmitted through the multimode optical fiber (38) and outgoing from the multimode optical fiber; a refractive index measuring means for measuring the refractive index of a thin film formed over the surface of the film monitor (36), and a calculating unit (48) that calculates changes in the optical characteristics and the thickness of the thin film on the basis of the output of the optical detector (55).

5. A film forming apparatus according to claim 4 further comprising a control means for controlling film forming conditions dominating the mode of the film forming process according to data representing changes in the optical characteristics and the thickness of the thin film, provided by the film monitoring system.

6. A film forming apparatus comprising:
 a film forming system having a fundamental configuration necessary for forming a thin film; and
 a film monitoring system comprising: a light source unit having a lamp or a laser as a light source (40), an optical coupling device (39) mounted on a flat plate to receive light emitted by the light source (40), a flat film monitoring plate, a polarizing filter for separating incident light and return light propagated through the flat film monitoring plate and reflected by the end surface of the flat film monitoring plate, a light measuring unit for measuring the quantity of the return light, consisting of a spectroscope (53) and an optical detector (55), and a computing unit (48) that calculates changes in the optical characteristics of a thin film formed over the surface of the flat film monitoring plate and having a refractive index greater than that of the flat film monitoring plate on the basis of the outputs of the optical detector (55);

characterized in that film forming conditions dominating the mode of the film forming process are controlled according to data representing changes in the optical characteristics and the thickness of the thin film, provided by the film monitoring system.

7. A chemical vapor deposition system having a film forming vessel defining a film forming chamber (31), and provided with a film monitoring system comprising:

a light source unit (40);

an optical waveguide (38) formed of an optical fiber consisting of a core and a cladding for cladding the core, and having a film monitor (36) formed by exposing a portion of the core, and disposed with its film monitor disposed near a film forming unit disposed within the film forming chamber (31);

a driving unit for driving the film monitor for rotation;

a light measuring unit consisting of a spectroscope (53) and an optical detector (55), for measuring the quantity of light propagated through the optical waveguide (38) and outgoing from the optical waveguide; and

a computing unit (48) that calculates changes in the optical characteristics and the thickness of a thin film formed over the surface of the film monitor (36) and having a refractive index greater than that of the core on the basis of the outputs of the optical detector (55).

8. A chemical vapor deposition system according to claim 7 further comprising a control means for controlling at least the partial pressures of gases, the beam current, the voltage applied across the electrodes or the temperature of the substrate on which a thin film is to be formed, according to data representing changes in the optical characteristics and the thickness of a thin film formed over the surface of the film monitor, provided by the film monitoring system.

9. A chemical vapor deposition system according to claim 7, wherein film forming conditions including current supplied to the evaporation source and the temperature of the substrate and dominating the mode of the film forming process according to the data representing changes in the optical characteristics and the thickness of the thin film formed over the surface of the film monitor.

10. A film monitoring system comprising:

a light source unit (40);

an optical waveguide (38) formed of an optical fiber consisting of a core, a cladding for cladding the core, and a jacket, and having a film monitor (36) formed by partly or entirely removing a portion of the cladding in a section of the optical fiber extending near a film forming unit disposed within a film forming chamber (31) of a film forming system;

a light measuring unit consisting of a spectroscope (53) and an optical detector (55), for measuring the quantity of light propagated through the optical waveguide (38) and outgoing from the optical waveguide; and

a computing unit (48) that calculates changes in the optical characteristics and the thickness of a thin film formed over the surface of the film monitor (36) and having a refractive index greater than that of the core.

11. A film forming method employing a multimode optical waveguide consisting of a core of $N_1$ in refractive index, a cladding and a protective jacket, said film forming method comprising:

measuring the attenuation factor of transmitted light transmitted through the multimode optical waveguide and attenuated by refraction and interference in a thin film of $N_2$ in refractive index greater than the refractive index $N_1$ of the core, formed over the surface of a film monitor included in the multimode optical waveguide and formed by partly or entirely removing a portion of the cladding of the multimode optical waveguide, as a function of the wavelength of the transmitted light; and

determining optimum film forming conditions for forming a thin film of a desired quality, on the basis of changes in the thickness and the optical constant of the thin film formed over the surface of the film monitor.

12. A film forming method employing a multimode optical fiber consisting of a core of $N_1$ in refractive index, a cladding and a protective jacket, said film forming method comprising:

measuring the attenuation factor of transmitted light transmitted through the multimode optical fiber and attenuated by refraction and interference in a thin film of $N_2$ in refractive index greater than the refractive index $N_1$ of the core, formed over the surface of a film monitor formed by partly or entirely removing a portion of the cladding of the multimode optical fiber, as a function of the wavelength of the transmitted light; and

determining optimum film forming conditions for forming a thin film of a desired quality over the surface of a substrate, on the basis of changes in the thickness and the optical constant of the thin film formed over the surface of the film monitor.

13. A film forming method including a method of measuring changes in the quantity and the polarizing angle of phase-modulated light fallen at a fixed incident angle on one end of a flat plate of $N_1$ in refractive index, propagated through the flat plate and outgoing from the other end of the flat plate at a fixed outgoing angle, said film forming method comprising:

measuring the attenuation factor of the transmitted light attenuated by refraction and interference in a thin film formed over the surface of the flat plate and having a refractive index $N_2$ greater than the refractive index $N_1$ of the flat plate, as a function of the wavelength of the transmitted light; and

determining optimum film forming conditions for forming a thin film of a desired quality over the surface of a substrate, on the basis of changes in the thickness and the optical constant of the thin film formed over the surface of the flat plate.

14. A film forming method including a method of measuring changes in the quantity and the polarizing angle of light fallen at a fixed incident angle on one end of a flat plate of $N_1$ in refractive index, propagated through the flat plate, reflected at a fixed reflection angle by the other end of the flat plate and returned to the plane of incidence, said film forming method comprising:

measuring the attenuation factor of the transmitted light attenuated by refraction and interference in a thin film formed over the surface of the flat plate and having a refractive index $N_2$ greater than the refractive index $N_1$ of the flat plate, as a function of the wavelength of the transmitted light; and

determining optimum film forming conditions for forming a thin film of a desired quantity over the surface of a substrate, on the basis of changes in the thickness and the optical factor of the thin film formed over the surface of the flat plate.

15. A film forming method including a method of measuring the attenuation factor of transmitted light transmitted through a multimode optical waveguide consisting of a core, a cladding for cladding the core, and a protective jacket, said film forming method comprising:

measuring a change in the transmittance due to interference in the transmittance spectrum of the transmitted light when an amorphous or crystalline semiconductor thin film is formed over the surface of a film monitor formed by partly or entirely removing a portion of the cladding of the multimode optical waveguide; and

determining optimum film forming conditions for forming an amorphous or crystalline semiconductor film of a desired quality over the surface of a substrate, on the basis of changes in the thickness and the optical constant of the amorphous or crystalline semiconductor film formed over the surface of the film monitor.

16. A film forming method including a method of measuring the attenuation factor of transmitted light transmitted through a multimode optical waveguide consisting of a core, a cladding for cladding the core, and a projective jacket, said film forming method comprising:

measuring a change in the transmittance due to interference in the transmittance spectrum of the transmitted light in a wavelength range corresponding to the band gap of a dielectric thin film having a refractive index greater than that of the core and formed over the surface of a film monitor formed by partly or entirely removing a portion of the cladding of the multimode optical waveguide;

monitoring changes in the thickness and the optical constant of the dielectric thin film; and

determining optimum film forming conditions for forming a dielectric thin film of a desired quality over the surface of a substrate, on the basis of data obtained by monitoring changes in the thickness and the optical constant of the dielectric thin film formed over the surface of the film monitor.

17. A film forming method including a method of measuring the attenuation factor of transmitted light transmitted through a multimode optical waveguide consisting of a core, a cladding for cladding the core, and a protective jacket, said film forming method comprising:

measuring a change in the transmittance due to interference in the transmittance spectrum of the transmitted light in a wavelength range corresponding to the plasma edge of a metal thin film having a refractive index greater than that of the core and formed over the surface of a film monitor formed by partly or entirely removing a portion of the cladding of the multimode optical waveguide;

monitoring changes in the thickness and the optical constant of the metal thin film; and

determining optimum film forming conditions for forming a metal thin film of a desired quality over the surface of a substrate.

# FIG. 1

INPUT POWER P0

INTERNAL REFLECTIVITY R

TRANSMITTED POWER P

CORE 1

CLADDING 2

3 FILM MONITOR

TRANSMITTANCE T=P/P0

# FIG. 2

CORE 1

CLADDING 2

4 FILM MONITOR

FILM-COATED SURFACE

EP 0 652 304 A1

FIG. 3

## FIG. 4

## FIG. 5

## FIG. 6(a)

CLADDING 61

CORE 62

63
HEAT-
JACKET
RESISTANT
(ALUMINUM
FOIL)

← 100 mm →

## FIG. 6(b)

CORE 62

61

## FIG. 7

WAFER HOLDER 71

ROTATING DIRECTION

WAFER 72

74
FILM MONITOR

INCIDENT LIGHT

73
TEMPERATURE
MONITOR

## FIG. 8

HEATER 81

85
SUBSTRATE
HOLDER

INCIDENT
LIGHT
82

86
SUBSTRATE

91
OUTGOING
LIGHT

83
FILM-COATED
SURFACE

84
FILM MONITOR

14

# FIG. 9

OPTICAL FIBER 87

90
INCIDENT
LIGHT

FILM MONITOR 84

86
PLANE-PARALLEL
PLATE

91
OUTGOING
LIGHT

# FIG. 10

P
S

97
INCIDENT LIGHT

OUTGOING
LIGHT
98

Ts, Tp

99
FILM-COATED
SURFACE

FIG. 11

COMPUTER 116

RF POWER SOURCE

POWER SUPPLY
CONTROL SYSTEM

13.56MHz

COMPUTER 116

HEATER
CONTROL
SYSTEM

112

SUBSTRATE
HOLDER
117

FILM FORMING
CHAMBER
101

HEATER
104

SUBSTRATE
103

FLOW
CONTROLLER

SOURCE GAS
SUPPLY SYSTEM

113

114

109

DRIVING
UNIT

DRIVING
UNIT

108

108

CONTROL LINE

OPTICAL WAVEGUIDE

PLASMA

LAMP

OPTICAL
COUPLER

105
FILM
MONITOR

102
TARGET

OPTICAL
COUPLER

INTERFERO-
METER

COM-
PUTER

107

107

115

116

EVACUATING
SYSTEM
106

POWER SUPPLY
CONTROL
SYSTEM
109

HEATER
CONTROL
SYSTEM 112

16

EP 0 652 304 A1

## FIG. 12

FILM MONITOR
212

HEATER POWER UNIT 211

SUBSTRATE 230

229  HEATER

213  DRIVING UNIT

228  DRIVING UNIT

OPTICAL WAVEGUIDE 214

226 OPTICAL WAVEGUIDE

217 TARGET

ION BEAM

ION GUN 227

LAMP  215

216 OPTICAL COUPLER

EVACUATING SYSTEM 218

ION GUN POWER UNIT  219

COMPUTER 223

POLYCHROMETER 224

MULTI-CHANNEL ANALYZER 225

223 COMPUTER

222 DATA BASE

FLOW CONTROLLER 231

SOURCE GAS

SOURCE GAS

221 HEATER CONTROL SYSTEM

EP 0 652 304 A1

European Patent
Office

# EUROPEAN SEARCH REPORT

Application Number

## DOCUMENTS CONSIDERED TO BE RELEVANT

EP 94114707.6

| Category | Citation of document with indication, where appropriate, of relevant passages | Relevant to claim | CLASSIFICATION OF THE APPLICATION (Int. Cl. 6) |
|---|---|---|---|
| A | <u>EP - A - 0 233 610</u><br>(SONY CORPORATION)<br>　　* Abstract; fig. 1;<br>　　　claims 1-19 *<br>　　　　--- | 1-17 | C 23 C 16/52<br>C 23 C 14/54 |
| A | <u>US - A - 4 936 964</u><br>(KENJI NAKAMURA)<br>　　* Abstract; fig. 1;<br>　　　claims 1-4 *<br>　　　　--- | 1-17 | |
| A | <u>EP - A - 0 545 699</u><br>(HUGHES AIRCRAFT COMPANY)<br>　　* Abstract; fig. 5;<br>　　　claims 1-10 *<br>　　　　---- | 1-17 | |
| | | | TECHNICAL FIELDS<br>SEARCHED (Int. Cl. 6)<br><br>C 23 C |

The present search report has been drawn up for all claims

| Place of search | Date of completion of the search | Examiner |
|---|---|---|
| VIENNA | 13-12-1994 | HAUK |

EPO FORM 1503 03.82 (P0401)